(19) Europäisches Patentamt
European Patent Office
Office européen des brevets

(11) **EP 1 805 772 B1**

(12) **FASCICULE DE BREVET EUROPEEN**

(45) Date de publication et mention de la délivrance du brevet:
**30.04.2014 Bulletin 2014/18**

(21) Numéro de dépôt: **05814925.3**

(22) Date de dépôt: **26.10.2005**

(51) Int Cl.:
**H01F 1/153** (2006.01)     **H01F 38/28** (2006.01)

(86) Numéro de dépôt international:
**PCT/FR2005/002686**

(87) Numéro de publication internationale:
**WO 2006/048533 (11.05.2006 Gazette 2006/19)**

(54) **TORE NANOCRISTALLIN POUR CAPTEUR DE COURANT, COMPTEURS D'ENERGIE A SIMPLE ET A DOUBLE ETAGE ET SONDES DE COURANT LES INCORPORANT**

NANOKRISTALLINER KERN FÜR EINEN STROMSENSOR, EIN- UND ZWEISTUFIGE ENERGIEMESSGERÄTE UND STROMSONDEN DAMIT

NANOCRYSTALLINE CORE FOR A CURRENT SENSOR, SINGLE AND DOUBLE-STAGE ENERGY METERS AND CURRENT PROBES CONTAINING SAME

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **29.10.2004 FR 0411618**

(43) Date de publication de la demande:
**11.07.2007 Bulletin 2007/28**

(60) Demande divisionnaire:
**10184081.7 / 2 293 308**

(73) Titulaire: **Aperam Alloys Imphy**
**93200 Saint Denis (FR)**

(72) Inventeurs:
• **WAECKERLE, Thierry**
**58000 Nevers (FR)**
• **SIMON, Fabien**
**91560 Crosne (FR)**
• **ALVES, Francisco**
**94500 Champigny-Sur-Marne (FR)**
• **SAVE, Thierry**
**58660 Coulanges Les Nevers (FR)**
• **DEMIER, Alain**
**58640 Varennes Vauzelles (FR)**

(74) Mandataire: **Jacobson, Claude et al**
**Cabinet Lavoix**
**2, Place d'Estienne d'Orves**
**75441 Paris Cedex 09 (FR)**

(56) Documents cités:
EP-A- 0 563 606     WO-A-03/067615
WO-A-2004/088681     FR-A- 2 823 507
JP-A- 1 287 250     US-B1- 6 563 411

• UEDA Y ET AL: "PERMEABILITY AND ALPHA-FE PHASE PRECIPITATED IN FE-SI-B-CU-NB AMORPHOUS ALLOYS" IEEE TRANSLATION JOURNAL ON MAGNETICS IN JAPAN, IEEE INC, NEW YORK, US, vol. 9, no. 6, 1 novembre 1994 (1994-11-01), pages 39-46, XP000548724 ISSN: 0882-4959

**Description**

L'invention concerne un tore magnétique utilisé pour la fabrication d'un composant inductif, de type capteur de courant.

Dans le cas des composants pour capteur de courant et notamment pour capteur de courant alternatif, comportant éventuellement une composante continue superposée significative, il est nécessaire de disposer de tores ayant des perméabilités réduites afin de ne pas saturer le tore, sans toutefois être trop faibles pour conserver une bonne précision de mesure du capteur. Il faut que les performances du capteur soient stables sous des champs de polarisation élevés et dans une plage de température aussi large que possible et dans certains cas, dans une large bande de fréquence.

De tels capteurs de courant trouvent notamment un usage dans les transformateurs de compteurs d'énergie électrique, qui à la fois isolent tout le dispositif du réseau de charge sous tension et fournissent le signal électrique qui sert au comptage d'énergie.

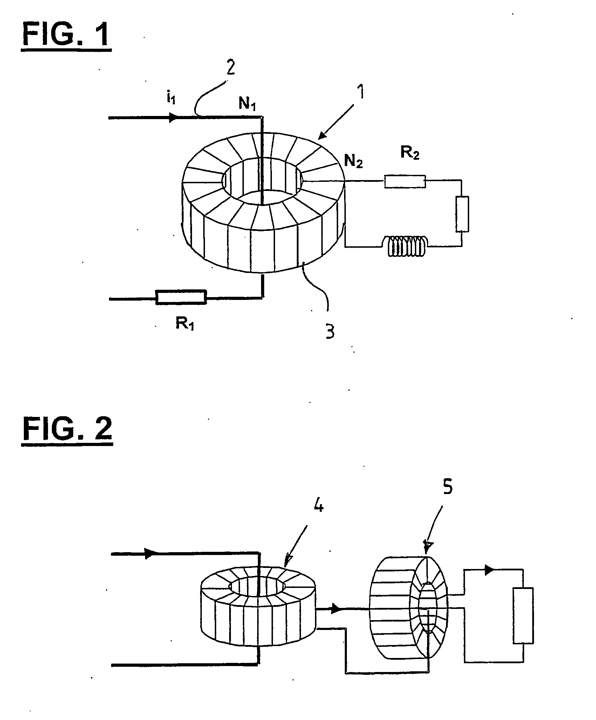

Un transformateur de courant à branchement direct sur le courant de charge (de type 1 selon la norme IEC 1026 ; dans tout le document, lorsqu'on se réfère à cette norme, on se réfère à son édition antérieure mais la plus proche du 30.10.2004) comporte un seul étage, qui prend la forme d'un tore cumulant à la fois les fonctions de transformateur-isolateur et de capteur de courant pour comptage d'énergie. Comme on peut le voir en figure 1, un tel transformateur repéré généralement par 1 à la figure 1, est généralement constitué de trois parties :

- un circuit magnétique torique (non directement visible sur la figure) pour minimiser les fuites magnétiques,
- un enroulement primaire 2 de $N_1$ spires de résistance $R_1$ se ramenant souvent à un simple conducteur traversant le tore ($N_1 = 1$) et parcouru par un courant $i_1$,
- un enroulement secondaire 3 de $N_2$ spires de résistance $R_2$ (de l'ordre de 2500 en général) parcouru par un courant $i_2$,

Un capteur de courant est de bonne précision pour le comptage d'énergie si le déphasage entre courant et tension est très faible, et si la relation entre courants primaire et secondaire est la plus linéaire possible. Cela s'obtient en particulier par une inductance magnétisante $A_L$ la plus élevée possible, ce qui implique qu'on dispose d'un très grand nombre de spire secondaire $N_2$, mais aussi d'une perméabilité $\mu$ aussi élevée que possible. En effet, qu'il y ait ou non une composante continue superposée $I_{CC}$ au courant alternatif à mesurer $I_1$, il ne faut pas que l'ensemble de ces courants amène le tore à proximité de la zone de saturation, car alors la relation B-H ne serait plus du tout linéaire. Si on appelle $\Delta B$ l'étendue de la plage d'induction où la relation B-H est approximativement linéaire, le champ critique à ne pas dépasser sous peine de saturation est alors $\Delta B/\mu max$ et la condition de non saturation qui en découle est la suivante :

$$I_{max} = |(I_{CC} + I_1)| < N_1.( \Delta B/\mu_{max}).$$

Ceci signifie que plus le courant maximum admissible à mesurer Imax croît, plus la perméabilité du matériau devra être diminuée pour échapper à la saturation.

En pratique pour les plus petits calibres de mesure (5 à 50A d'après la norme) auxquels se superposent d'éventuelles composantes continues, on utilise une structure de capteur à simple étage et un tore magnétique en alliage amorphe à base de cobalt.

Pour les calibres de courant de charge supérieurs à 50A, auxquels se superposent d'éventuelles composantes continues, la norme recommande une structure à double étage telle que représentée à la figure 2, avec transformateur de courant en tête repéré généralement par 4, chargé d'isoler et d'éliminer la composante continue semblable à celui du cas précédent, et un capteur de courant haute sensibilité repéré généralement par 5, en dérivation du transformateur. Comme ce dernier évite tout risque de saturation au capteur, on a tout intérêt à utiliser un noyau magnétique à très haute perméabilité.

Une autre application type de ces capteurs de courant est le contrôle de courant des composants actifs de puissance (IGBT, GTO, thyristor...) pour les dispositifs de moyenne et forte puissance. Ce type d'application nécessite que le capteur puisse mesurer des courants variant très vite et souvent dans le temps, et donc qu'il dispose d'une grande dynamique de mesure, qui couvre une plage de fréquence de mesure la plus grande possible, typiquement d'au moins 1 MHz. Le capteur le plus performant est celui qui a le maximum de précision et de dynamique de mesure pour un encombrement global le plus faible.

Pour de tels équipements, on utilise des structures à double étage semblable à celui qui vient d'être décrit, avec un transformateur de courant en tête à faible perméabilité équivalente et un capteur de courant en dérivation basé sur un noyau magnétique à haute perméabilité et grande stabilité fréquentielle tel qu'un tore nanocristallin conventionnel à haute perméabilité ($\mu$>20 000).

Les performances demandées aux tores de transformateur de capteur de courant exposés soit à des composantes fortes de courant continu superposé (application compteur d'énergie) soit à de fortes et rapides variations de courant (application à la mesure harmonique type sonde de courant pour contrôle des composants actifs de puissance) sont essentiellement les mêmes et peuvent être résumées ainsi :

- Le tore du composant inductif doit présenter une bonne stabilité thermique de ses propriétés magnétiques, ce qui permet en particulier de repousser plus haut la température limite de fonctionnement du composant et d'avoir une précision de mesure peu dépendante de la température de fonctionnement. Cette stabilité en température est typiquement de l'ordre de quelques % de variation de perméabilité entre -40°C et +60°C.
- Il doit en outre présenter un faible vieillissement dans des atmosphères pouvant excéder 100°C.
- La perméabilité sous champ alternatif du tore magnétique doit être limitée à un niveau de perméabilité tel que le matériau ne peut-être mis en saturation sous l'effet conjugué de la composante alternative fondamentale, de ses harmoniques éventuelles (cas de l'alimentation d'un semiconducteur de puissance) et de composante continue superposée éventuelle. Pour l'utilisation au sein d'un transformateur utilisé dans un compteur d'énergie, on préférera plus particulièrement une perméabilité magnétique relative inférieure à 4 000, et de préférence inférieure à 3000 tout en restant supérieure à 200, voire à 300.
- La solution magnétique utilisée ne doit pas comporter d'entrefer localisé, de manière à limiter la sensibilité aux rayonnements électromagnétiques parasites. Ceci permet également d'éviter d'avoir à utiliser un blindage.
- Il est nécessaire également de rechercher une induction à saturation Bs qui soit élevée, afin de miniaturiser le capteur et/ou d'améliorer sa précision. On préférera en particulier les tores présentant une induction à saturation Bs supérieure ou égale à 1T, voire supérieure à 1,2T.
- Pour les transformateurs de courant destinés à travailler sous composante continue superposée, il est souhaitable d'avoir une "forte linéarité B-H", c'est à dire une relation entre B et H aussi linéaire que possible sur une plage importante d'induction ΔB : on vise une variation maximale de μ sur cette plage d'au plus quelques %. En effet, plus ΔB est élevé, à plage de courant de polarisation $I_{cc}^{max}$ constant, plus la perméabilité peut être accrue et donc la précision du capteur ou bien plus le rayon et le volume du tore peuvent être réduits.
- Il est souhaitable, d'avoir une perméabilité efficace locale $\mu_{loc}$, sous composante de courant alternatif aussi indépendante que possible de la composante continue superposée $H_{cc}$ : on appelle perméabilité différentielle ou locale $\mu_{loc}$ la dérivée de B par rapport à H au point de fonctionnement B(H).
- Le tore doit également présenter de faibles pertes magnétiques pour limiter le déphasage entre courant et tension du capteur et donc accroître la précision.
- Il est souhaitable également que les propriétés magnétiques des composants inductifs soient peu sensibles aux contraintes externes, telles que les contraintes d'enrobage, de bobinage.
- En outre, la dynamique fréquentielle d'aimantation doit être bonne, c'est-à-dire que la fréquence de « coupure intrinsèque haute » est élevée, et plus particulièrement au moins égale à 1 MHz sans blindage du capteur. Dans le cadre de la présente invention, on appelle fréquence de coupure d'un matériau conducteur la fréquence pour laquelle on obtient le maximum d'amplitude de μ ", partie imaginaire complexe de la perméabilité et représentant les effets dissipatifs par courants induits.
- Le tore doit être le plus économique possible.

Pour réaliser des transformateurs de courant, il est commun d'utiliser des noyaux magnétiques toriques en alliage Fe Ni à 80 % de nickel, mais ces alliages ont une perméabilité relative qui varie sensiblement avec le champ de polarisation, tout en restant toujours très supérieure à 10 000. Ils sont donc inadaptés aux transformateurs de courant travaillant sous forte composante continue.

On a proposé, notamment dans US 6,507,262 B1, d'utiliser un alliage nanocristallin base fer du type Fe Co Cu Si B pouvant ne pas contenir de cobalt, ayant une perméabilité élevée, comprise entre 12 000 et 300 000. De même, on a proposé d'utiliser un alliage amorphe base cobalt ayant une perméabilité comparable. Ces deux solutions qui ont l'avantage de présenter des relations B-H très linéaires, présentent l'inconvénient d'avoir des perméabilités très élevées qui conduisent à la saturation de noyaux magnétiques dès que la composante continue du courant à mesurer atteint quelques ampères.

On a également proposé dans WO 2004/088681 A2 d'utiliser un alliage nanocristallin du type Fe Ni Co Cu Si B, de perméabilité inférieure à 15 000.

Par ailleurs, on connaît du document FR 2 823 507 A1 un tore réalisé dans un alliage nanocristallin du type Fe Cu Nb Si B, de perméabilité inférieure à 1000.

On a également proposé d'utiliser des noyaux magnétiques en alliage amorphe base cobalt ayant une perméabilité relative de quelques milliers réglée par recuit sous champ transverse. Ces alliages qui ont l'avantage d'avoir une perméabilité pas trop élevée, présentent cependant l'inconvénient d'avoir une induction à saturation inférieure à 0,8 Tesla, ce qui n'est pas favorable à l'obtention d'une bonne précision pour le capteur. En outre, ces alliages sont sensibles au vieillissement dès 100°C et le cobalt est un élément très coûteux.

On a aussi proposé d'utiliser un alliage nanocristallin Fe Co Nb Si B Cu contenant 60 % (atomique) de Co qui permet de régler la perméabilité jusqu'à des valeurs de quelques centaines ou quelques milliers tout en conservant certains des avantages des alliages nanocristallins Fe Cu Nb Si B, à savoir la stabilité en température des performances, la faible rémanence et le faible champ coercitif. Ces alliages présentent cependant l'inconvénient d'avoir une induction à saturation basse et de contenir beaucoup de cobalt qui est très coûteux.

On a enfin proposé des transformateurs de courant sans noyau magnétique (Capteur Rogowski) ou avec des noyaux magnétiques constitués de pots en ferrite. Ces capteurs présentent l'inconvénient d'être très sensibles aux champs magnétiques extérieurs qui viennent perturber les mesures. Pour éviter ces perturbations, il est nécessaire de prévoir des blindages magnétiques très coûteux.

Il apparaît qu'aucune des solutions connues n'est vraiment satisfaisante.

Le but de la présente invention est donc de proposer un tore enroulé ferromagnétique amélioré par rapport à ceux de l'art antérieur et qui soit en particulier, sans entrefer, à perméabilité magnétique relative réglable précisément entre 200 et 4000, apte à satisfaire les besoins des capteurs de courant pour compteur d'énergie, aussi bien en branchement direct avec structure à un seul étage, qu'en branchement sur transformateur de courant en structure à double étage, et apte à satisfaire également les besoins des sondes de courant pour contrôle dynamique de courant des composants actifs des systèmes électroniques, et ceci en occupant le volume le plus réduit possible, sans nécessiter l'usage d'un blindage et étant le plus économique possible.

A cet effet, l'invention a pour objet un tore enroulé nanocristallisé selon la revendication 1.

La perméabilité $\mu$ peut varier conformément à la revendication 2.

Dans un mode de réalisation préféré, la teneur en nickel est inférieure à 4,5%, ce qui a l'avantage de conduire à un coefficient de magnetostriction $\lambda$s très faible.

Dans un autre mode de réalisation préféré, le tore enroulé est conforme à la revendication 3.

Le tore selon l'invention a l'avantage d'être très économique puisqu'il ne contient pas de cobalt.

En outre, sa perméabilité efficace locale est très proche de sa perméabilité linéaire. En effet, les inventeurs ont constaté que cette perméabilité efficace locale $\mu_{loc}$ est d'autant plus proche de la perméabilité $\mu_{lin}$ correspondant à la pente d'un cycle d'hystérésis majeur, que la rémanence du cycle d'hystérésis est faible. Ainsi, on préfèrera les tores présentant une très faible rémanence Br, typiquement inférieure à 0,02T.

Un second objet de l'invention est constitué par un dispositif de mesure électrique selon la revendication 4.

Le dispositif de mesure électrique est, par exemple, un compteur d'énergie à simple étage conforme à la revendication 5.

Dans un mode de réalisation préféré, le compteur d'énergie est conforme à la revendication 6.

Le dispositif de mesure électrique peut, également, être un compteur d'énergie à double étage comprenant un tore de transformateur de courant et un tore de mesure, conforme à la norme IEC 1036 pour les calibres supérieurs à 50 A, dans lequel le tore de transformateur de courant est un tore selon l'invention dont la perméabilité $\mu$ est comprise entre 200 et 1000, et de préférence inférieure à 800.

Le dispositif de mesure électrique peut, aussi, être un compteur d'énergie conforme à la norme IEC 1036 pour les calibres supérieurs à 50 A, à simple étage et comprenant un tore selon l'invention dont la perméabilité $\mu$ est comprise entre 200 et 1000, et de préférence inférieure à 800.

De préférence, un compteur d'énergie selon l'invention est conforme à la revendication 7.

Le dispositif de mesure électrique peut, enfin, être une sonde de courant à grande dynamique de mesure pour contrôler les courants dans des composants actifs de puissance dans des dispositifs de moyenne ou de forte puissance, du type comprenant un tore de transformateur de courant et un tore de mesure, le tore de transformateur de courant étant un tore selon l'invention, dont la perméabilité $\mu$ est comprise entre 200 et 1000, et de préférence inférieure à 800.

Le tore magnétique selon l'invention est particulièrement bien adapté à l'utilisation dans un transformateur de courant destiné à mesurer un courant électrique alternatif sur lequel est superposé une composante continue importante et/ou des composantes harmoniques de tout ordre et d'amplitudes variées.

Ce tore nanocristallin est constitué d'une bande en matériau nanocristallin enroulée sur elle-même, sous la forme d'une bobine torique, obtenue à partir d'un ruban coulé dans un état amorphe, de composition atomique :

$$[Fe_{1-a}Ni_a]100\text{-}x\text{-}y\text{-}z\text{-}\alpha\text{-}\beta\text{-}\gamma Cu_x Si_y B_z Nb_\alpha M'_\beta M''_\gamma$$

avec $a \leq 0,3$, $0,6 \leq x \leq 1,5$, $10 \leq y \leq 17$, $5 \leq z \leq 14$, $2 \leq \alpha \leq 6$, $\beta \leq 7$, $\gamma \leq 8$, M' étant l'un au moins des éléments V, Cr, Al et Zn, M" étant l'un au moins des éléments (C, Ge, P, Ga, Sb, In, Be). Pour obtenir la structure nanocristalline, on soumet le ruban amorphe à un recuit sous traction de cristallisation, à l'état déroulé, en défilement et sous tension dans une direction sensiblement longitudinale axiale du ruban, de manière que le ruban soit maintenu à une température de recuit comprise entre 500 et 700°C, pendant une durée comprise entre 5 et 300 secondes, sous une contrainte de traction axiale, puis on enroule la bande nanocristalline, dans lequel la contrainte de traction axiale est comprise entre 2 MPa et 500 MPa afin d'obtenir une perméabilité magnétique comprise entre 200 et 4000, et de préférence entre 400 et 3000 pour les applications envisagées.

On pourra se référer à la demande FR 2 823 507 pour de plus amples détails sur le procédé de recuit sous traction.

De manière générale, les alliages utilisés pour la fabrication de bandes amorphes fer-silicium ont la composition atomique suivante :

$$[Fe_{1-a}Ni_a]100\text{-}x\text{-}y\text{-}z\text{-}\alpha\text{-}\beta\text{-}\gamma Cu_x Si_y B_z Nb_\alpha M'_\beta M''_\gamma$$

avec $a \leq 0{,}3$, $0{,}6 \leq x \leq 1{,}5$, $10 \leq y \leq 17{,}5 \leq z \leq 14{,}2 \leq \alpha \leq 6$, $\beta \leq 7$, $\gamma \leq 8$,
M' étant l'un au moins des éléments V, Cr, Al et Zn,
M'' étant l'un au moins des éléments C, Ge, P, Ga, Sb, In, Be.

Ces alliages peuvent avoir en particulier la composition pondérale suivante :

$Fe_{72}$ à $_{77} Cu_1 Nb_3 Si_{12,5}$ à $_{17} B_6$ à $_{12}$, le solde de l'alliage étant constitué essentiellement par des impuretés inévitables.

Le matériau est élaboré sous forme liquide puis coulé avec une forte vitesse de refroidissement, dans une installation de coulée de rubans amorphes à cylindre refroidi de type classique, de telle sorte qu'on obtienne en sortie de l'installation de coulée, une bande amorphe enroulée sous la forme d'une bobine à spires jointives.

Pendant le traitement, à l'intérieur du four et plus particulièrement dans la zone à température homogène du four, la bande en cours de traitement et en défilement est soumise à une force de traction dans sa direction longitudinale axiale qui est parfaitement ajustée en fonction des caractéristiques de la bande amorphe et régulée dans un intervalle étroit, pendant le traitement de la bande en défilement dans le four.

De plus, la bande obtenue et enroulée à la sortie du recuit flash peut être déroulée puis réenroulée, ce qui permet de réaliser des tores magnétiques dont les spires sont isolées les unes des autres, comme il sera expliqué plus loin. Dans tous les cas, on réalise un traitement de recuit au défilé ou recuit flash sous tension à une valeur précise de la force de traction, à une température bien définie et à une vitesse de défilement réglée.

De manière plus générale, en fonction des caractéristiques de la bande et de la température du four entre 600°C et 700°C, et de préférence entre 620°C et 690°C, le temps de maintien de la bande à la température de recuit peut être compris entre 5 et 300 secondes, et de préférence entre 10 et 60 secondes.

Il est possible de déterminer une courbe d'étalonnage de la valeur de la traction pour obtenir un niveau de perméabilité défini sur le ruban entre 200 et 4000.

Toutefois, pour obtenir un tore dans lequel on limite la circulation des courants induits et les pertes magnétiques, il est nécessaire d'éviter la formation de contacts électriques entre les spires, pendant l'enroulement du tore recuit. De manière à réduire les courants induits dans le tore et les pertes magnétiques, il peut être nécessaire, suivant les applications prévues pour le tore, de déposer ou de former une couche d'isolation électrique sur la bande pour isoler les spires successives les unes des autres. On peut par exemple déposer en continu, sur la bande après recuit, une substance minérale sur une épaisseur d'un dixième de micromètre à quelques micromètres.

Pour cela, il est possible de dérouler la bande de la bobine obtenue à la sortie de l'installation de recuit et de la réenrouler sous faible tension mécanique, en déposant éventuellement sur la bande déroulée, un matériau d'isolation électrique préalablement au réenroulage, de manière à isoler les unes des autres les spires successives du tore.

De manière générale, les conditions de cristallisation de la bande à l'intérieur du four en recuit dynamique sous tension sont telles que la bande comporte au moins 50 % en volume de nanocristaux dont la taille est comprise entre 2 et 20 nm. Les différents cristaux sont séparés les uns des autres par la matrice constituée par la fraction de l'alliage restée amorphe.

Le tore magnétique suivant l'invention présente l'avantage d'avoir un faible coefficient de magnétostriction. De ce fait, ses propriétés magnétiques ne sont pas modifiées, lorsqu'on réalise des opérations d'enrobage, d'imprégnation, de bobinage, de collage... qui se traduisent par des contraintes exercées sur le tore. Ainsi, par exemple, lorsqu'un tore de l'invention est enrobé, sa perméabilité linéaire varie de moins de 5%, en particulier lorsqu'elle est mesurée à 20°C.

Le tore magnétique peut être rond, ovale ou carré sans entrefer.

La figure 1 est un schéma de principe d'un compteur d'énergie à simple étage.
La figure 2 est un schéma de principe d'un compteur d'énergie à double étage.

La figure 3 et la figure 4 sont des diagrammes donnant respectivement les cycles d'hystérésis à saturation (H max = 20 Oe) et linéaire (H max = 1 Oe) d'un tore.

Les figures 5 et 6 sont des courbes représentant le rapport de la perméabilité magnétique pour un courant (ou champ H) ayant une composante continue (ou champ $H_{cc}$ correspondant dans le cas de la figure 6 ou 7) non nulle sur la perméabilité magnétique pour un courant (ou champ H) ayant une composante continue nulle, pour différents matériaux.

La figure 7 est une courbe donnant la perméabilité d'un tore en fonction de la température.

La figure 8 représente les courbes (perméabilité/amplitude de la composante continue superposée) pour trois tores réalisés à partir de la même bande amorphe.

La figure 9 représente la stabilité de $\mu$ en fonction de la température pour un tore de recuit flash selon l'invention et pour un amorphe base cobalt.

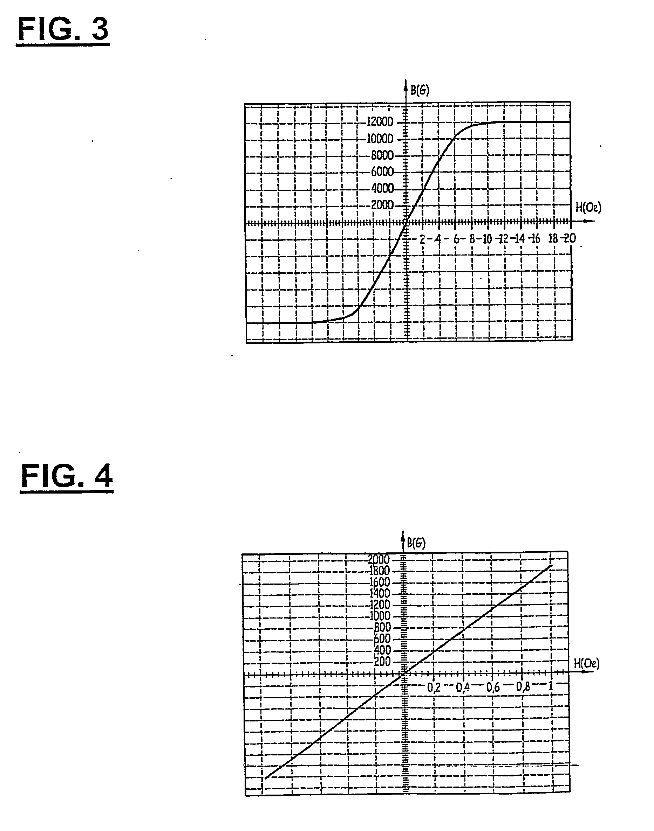

A titre d'exemple, on a réalisé la cristallisation en nanocristaux dans la matrice amorphe d'une bande amorphe de composition $Fe_{73 \cdot 5}Cu_1Nb_3Si_{15.5}B_7$, par le procédé déjà connu, en appliquant une traction de 50 Mpa pendant le passage entre le dérouleur et l'enrouleur et avec un passage dans la partie du four à 655°C durant 35 secondes. La bande amorphe était pré-isolée par passage dans un bain de méthylate de magnésium. Après réenroulage en un tore de diamètre intérieur 20 mm, une caractérisation par méthode fluxmètrique en courant continu montre (figure 4) que le cycle d'hystérésis à saturation (champ maximal appliqué de 20 Oe) est très linéaire dans sa partie correspondant à un champ allant jusqu'à 6 ou 7 Oe : ainsi, si on restreint le champ maximum appliqué (alternatif et/ou continu) en dessous des 6 ou 7 Oe, comme par exemple 1 Oe, le matériau ne travaille qu'en cycle d'hystérésis extrêmement linéaire et mince (figure 4) ce qui correspond à l'idéal d'un capteur de courant.

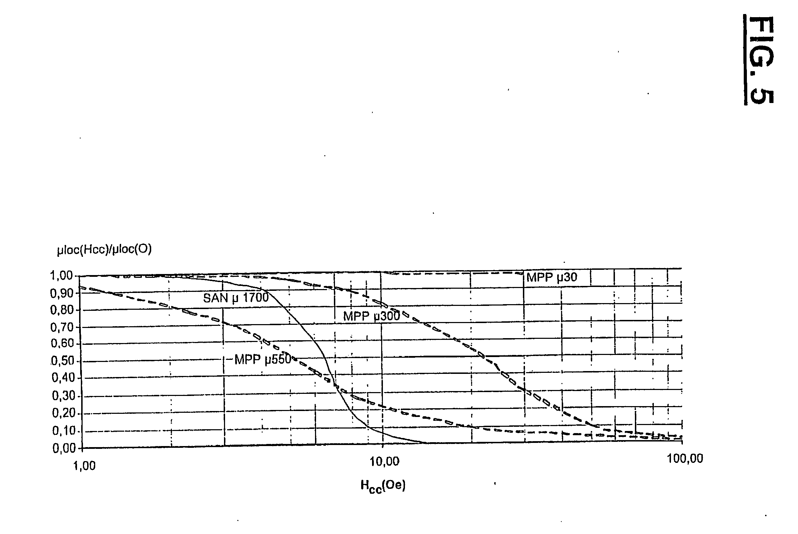

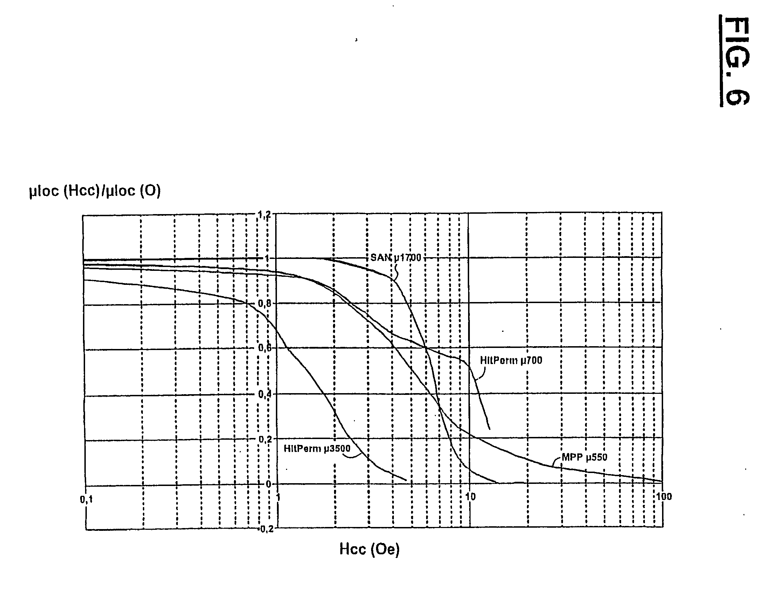

La rémanence est si faible qu'il est difficile d'en donner une valeur différente de 0 à l'imprécision de mesure près. Il est en tout cas certain qu'elle est inférieure à 0,02T. Le champ coercitif de 21 mOe est également très faible et permet de penser que les perméabilités locales $\mu_{loc}$ (appelées aussi différentielles) mesurées à 10 kHz avec composante continue superposée Hcc seront très proche de $\mu_{lin}$ et très stables en fonction de Hcc. Ceci est vérifié par les courbes représentées aux figures 5 et 6 où on voit, par comparaison avec des poudres de FeNi compactées (MPP) et des alliages nanocristallins base cobalt (Hitperm), que la perméabilité des tores de l'invention (SAN) reste beaucoup plus stable lorsque des niveaux de perméabilité voisins sont comparés.

Ces courbes qui représentent le rapport entre la perméabilité locale $\mu_{loc}$ ($H_{cc}$) pour un champ continu superposé $H_{cc}$, et la perméabilité locale $\mu_{loc}$ (0) pour un champ continu superposé nul, en fonction du champ continu superposé $H_{cc}$, pour différents matériaux caractérisés par leur perméabilité linéaire $\mu_{lin}$, montrent que :

- pour un noyau selon l'invention ayant une perméabilité relative linéaire de 1700 (SAN $\mu1700$), le rapport $\mu_{loc}$ ($H_{cc}$) / $\mu_{loc}$ (0) reste quasiment égal à 1 pour un champ $H_{cc}$ allant jusqu'à 2 Oe environ,
- pour les alliages nanocristallins base cobalt Hitperm $\mu700$ et $\mu3500$, le rapport $\mu_{loc}$ ($H_{cc}$) / $\mu_{loc}$ (0) devient inférieur à 0,9 dès que le champ $H_{cc}$ atteint 0,1 Oe,
- pour les poudres FeNi compactées, le rapport $\mu_{loc}(H_{cc})/\mu_{loc}(0)$ reste stable uniquement pour les échantillons correspondant à des perméabilités faibles (MPP $\mu300$ et MPP $\mu30$), et pour une perméabilité relative de 550 (MPP $\mu550$), le rapport $\mu_{loc}$ ($H_{cc}$) / $\mu_{loc}$ (0) se dégrade très vite.

Ce comportement très favorable est à relier directement à la très bonne linéarité du cycle d'hystérésis B-H tant que le coude de saturation n'est pas atteint et tel qu'on le voit sur la figure 1 qui représente un cycle d'hystérésis. La rémanence $B_r$, est très faible, et on a $\mu_{loc} = \mu_{lin}$ et donc $\mu_{loc}$ indépendant de $H_{cc}$ ce qui est l'idéal pour l'application.

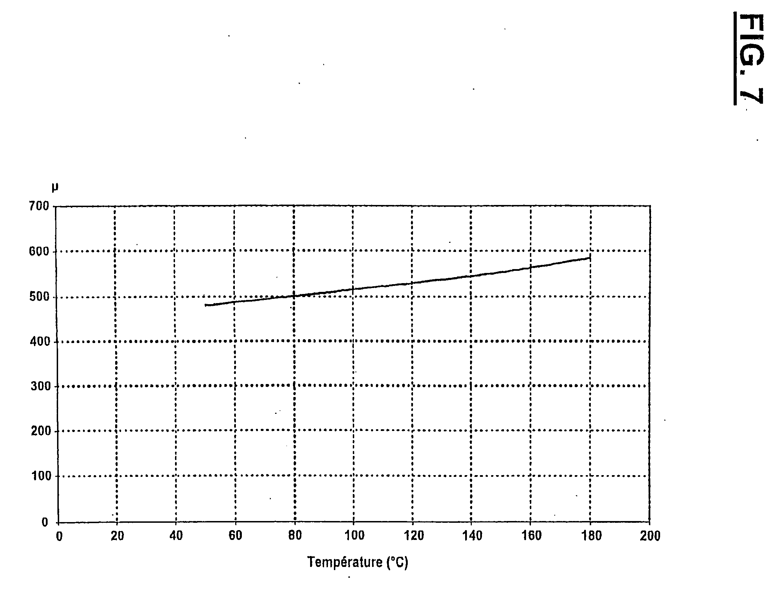

On voit en figure 7 que la variation relative de perméabilité $\mu_{lin}$ entre 20° C et 100° C n'excède pas 10.

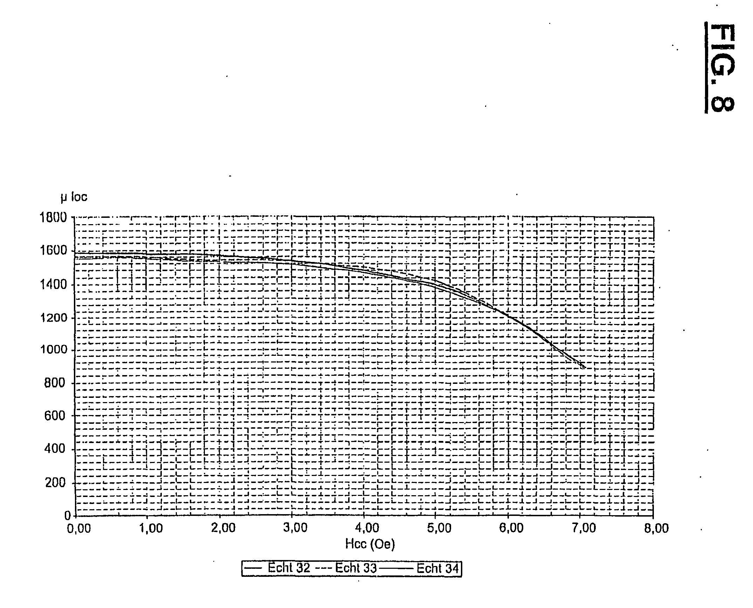

Pour évaluer la reproductibilité du procédé de fabrication, trois tores nanocristallins ont été réalisés selon l'invention avec la même bande amorphe de départ et la même traction de 50 Mpa par enroulage. Comme le montre la figure 8, les écarts de caractéristiques entre les trois tores restent inférieurs à 5 %.

La perméabilité magnétique du tore de l'invention, varie au total de moins de 15 % lorsque la température varie entre -25° C et +60° C, qui est le plage maximale de température de fonctionnement pour la plupart des applications de comptage d'énergie. A titre de comparaison, un amorphe base cobalt classique varie de 16%.

| Cas de tores enroulés avec $\mu_{lin} \approx 1700$ | Tore de l'invention | Tore amorphe base cobalt |
|---|---|---|
| $[\mu_{lin}(T)-\mu_{lin}(20°C)] / \mu_{lin}(20°C)$ en % entre -25°C et +60°C | -7%/+6% | -15%/+1% |
| $[\mu_{lin}(T)-\mu_{lin}(20°C)] / \mu_{lin}(20°C)$ en % entre -40°C et +120°C | -8%/+17% | -15%/+1% |

Certaines application ont besoin de fonctionner jusqu'à 120°C : dans ce cas les performances deviennent plus favorables à l'amorphe base cobalt.

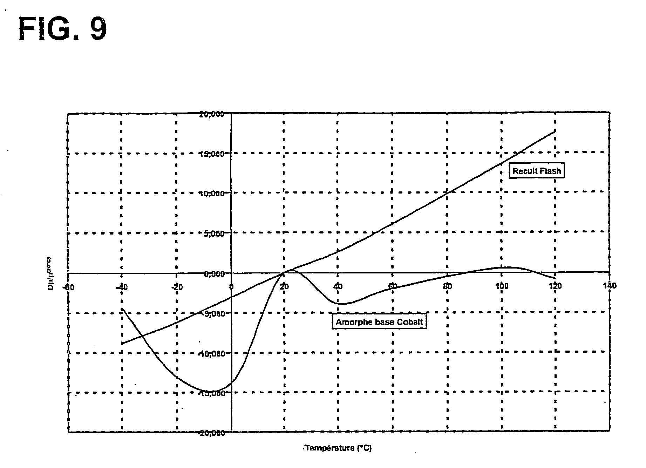

En revanche les tores de l'invention présentent le grand avantage sur les amorphes base cobalt que la perméabilité évolue de façon monotone et presque linéaire avec la température ce qui permet de procéder à une correction électronique aisée de la mesure en fonction de la température, alors que cela paraît beaucoup plus difficile pour l'amorphe base cobalt. On peut en particulier le constater sur la figure 9.

En outre, les inventeurs ont constaté que la variation à peu près linéaire de la perméabilité avec la température pouvait s'observer jusqu'à - 100°C. En particulier, des mesures d'écart entre la perméabilité à la température T et à 0°C ont donné les résultats suivants :

| T°C | 0 | -20 | -40 | -60 | -80 | -100 |
|---|---|---|---|---|---|---|
| $\Delta\mu/\mu$ en % | 0 | -0,8 | -2,1 | -3,6 | -5,4 | -7,3 |

En outre, le tore selon l'invention vieillit très peu sous l'effet de la température. On a ainsi pu mesurer moins de 1% de baisse de perméabilité linéaire mesurée à 20°C, après un étuvage de 100h à 120°C. Par comparaison un amorphe base cobalt dans les mêmes conditions voit sa perméabilité baisser de 5 à 6%.

On voit sur le tableau ci-dessous que des linéarités de mieux que 5 ou 2% peuvent être garanties sur les tores de l'invention sur des plages d'induction de l'ordre de 1T. On voit aussi qu'à linéarité identique, le tore de l'invention propose une plage d'induction de fonctionnement d'environ 10% plus élevée qu'un amorphe base cobalt.

| Cas de tores enroulés avec $\mu_{lin} \approx 1700$ | Tore de l'invention | Tore amorphe base cobalt |
|---|---|---|
| $\Delta B$ accessible pour $\Delta\mu_{loc}/\mu_{loc} < 2\%$ | $\Delta Bmax = 1,06$ T | $\Delta Bmax = 0,94$ T |
| $\Delta B$ accessible pour $\Delta\mu_{loc}/\mu_{loc} < 5\%$ | $\Delta Bmax = 1,12$ T | $\Delta Bmax = 1,03$ T |

On note enfin que la fréquence de coupure du matériau de l'invention (correspondant à la fréquence où le maximum d'amplitude de la perméabilité imaginaire $\mu''$ mesurée sur un impédancemètre est obtenu) est supérieure à 2 MHz, soit environ 2 fois la fréquence de coupure d'un alliage nanocristallin base cobalt (Hit.perm) dont les perméabilités de 590 et 2860 encadrent celle du matériau de l'invention comme le montre le tableau ci-dessous. La stabilité dynamique des tores de l'invention est donc très bonne et, de ce fait, se prête bien à l'utilisation dans des capteurs de courant à double étage type sonde de courant.

| Matériau | $\mu'$(10kHz) | Fréquence $f_c$ $f_c$ (Max $\mu''$) |
|---|---|---|
| Hitperm | 590 | 1 MHz |
|  | 2860 | 1 MHz |
| invention | 1560 | 2 MHz |

En outre, la fréquence de coupure intrinsèque peut atteindre 10MHz et plus pour les basses perméabilités.

L'induction à saturation Bs du tore peut être supérieure à 0,9 Tesla et même à 1 Tesla, voire 1, 2 Teslas. Par comparaison un amorphe base cobalt n'atteindra pas 1T de saturation.

Par ailleurs, les inventeurs ont étudiés l'influence du nickel et du cobalt, qui est un élément dont les effets sont comparables à ceux du nickel, sur les propriétés des alliages concernés par la présente invention.

Le tableau ci-dessous donne, pour un alliage dont la composition en atomes % est $(Fe_{100-x-y}Co_x Ni_y)_{74}Cu_1Nb_3Si_{15}B_7$, la plage de perméabilité accessible par le traitement thermique selon l'invention, le champ coercitif Hc, le coefficient de magnétostriction $\lambda_s$, le rapport des perméabilité à 150°C et à 25°C, et les pertes magnétiques à 500kHz, pour une induction de 50 mT à 27°C.

| x | y | Plage de $\mu$ accessible | Hc (A/m) | $\lambda_s$ (en ppm) | $\mu(150°C)/\mu(25° C)$ | Pertes magnétiques à 500kHz, 50mT, 27°C (en mW/cm$^3$) |
|---|---|---|---|---|---|---|
| 0 | 0 | 4000 à 200, voire moins | 3 | $-0,5 < \lambda_s < +0,5$ | 1,2 | 230 |
| 1,7 | 0 | $\mu > 300$ | 4 | 0,8 | 1,4 | 480 |
| 4,9 | 0 | $\mu > 600$ | 6 | 1,3 | 1,5 | 1225 |

(suite)

| x | y | Plage de μ accessible | Hc (A/m) | $\lambda_s$ (en ppm) | μ(150°C)/μ(25° C) | Pertes magnétiques à 500kHz, 50mT, 27°C (en mW/cm$^3$) |
|---|---|---|---|---|---|---|
| 2 | 1 | μ > 350 | 4,5 | 1 | 1,45 | 610 |
| 2,2 | 3 | μ > 400 | 4,8 | 1,5 | 1,6 | 780 |

Sur ce tableau, on peut constater, notamment que, plus la somme des teneurs en nickel et en cobalt est faible, plus le coefficient de magnétostriction est faible en valeur absolue.

Plus généralement, les inventeurs ont constaté que, lorsque la somme des teneurs en nickel et cobalt reste inférieure à 5%, et mieux à 4%, le coefficient de magnétostriction restait, en valeur absolue, inférieur à 2 ppm, et pouvait même être inférieur à 1 ppm.

Cette propriété est particulièrement intéressante puisque la sensibilité de l'alliage aux contraintes externes (collage, enrobage, imprégnation, découpe, manutention, etc...) et d'autant plus faible que le coefficient de magnétostriction est faible.

L'alliage utilisé pour la présente invention ne contient, en principe, pas de cobalt, essentiellement pour des raisons d'économie. Cependant, du fait des conditions d'élaboration, l'alliage peut contenir un peu de cobalt, à l'état de traces, c'est-à-dire, en des teneurs inférieures à 0,5%.

Dans ces conditions, afin d'obtenir des tores très peu sensibles aux contraintes engendrées lors de la fabrication, il est préférable que la teneur en nickel reste inférieure à 4,5%, mieux, inférieure à 4% et mieux encore, inférieure à 3%.

Dans le cas d'une sonde de courant, le tore de l'invention, grâce à sa haute saturation et sa perméabilité optimisée sans entrefer, grâce à sa fréquence de coupure dépassant 1 MHz permet de réduire la taille de la sonde de 80 à 98%, ce qui est un grand avantage dans les systèmes de contrôle des composants de puissance.

Exemple - Miniaturisation d'un transformateur à deux étages

Un transformateur de courant à deux étages selon l'invention a été construit sur la base des spécifications suivantes :

- Fréquence de coupure basse : 100 Hz -3 dB
- Fréquence de coupure haute :10 MHz -3dB
- Plage de fréquence de mesure : harmoniques entre 100Hz et 10MHz
- Gamme de mesure: 50 DC + 50 AC : courant de charge alternatif 50A + courant continu 50A superposé

Un transformateur selon l'art antérieur a été construit sur la base des mêmes spécifications, en utilisant un premier étage conventionnel en ferrite avec entrefer localisé, tandis que le transformateur selon l'invention a été construit en utilisant un premier étage en nanocristallins à faible perméabilité.

Les caractéristiques magnétiques et dimensionnelles des transformateurs obtenus sont rassemblées dans le tableau suivant, dans lequel :

Ae : section du noyau,
Le : périmètre moyen,
Volume : somme des volumes des 2 tores magnétiques,

$$Al = {}^*Ae/Le.$$

| | Configuration selon l'invention | | Configuration selon l'art antérieur | |
|---|---|---|---|---|
| | Tore 1 1$^{er}$ étage | Tore 2 2$^{nd}$ étage | Tore 3 1$^{er}$ étage | Tore 4 2$^{nd}$ étage |
| $A_e$ (m$^2$) | 0,40 | 0,24 | 3,15 | 0,22 |
| $L_e$(cm) | 4,5 | 2,4 | 16 | 6,3 |
| Volume (cm$^3$) | 2,376 | | 51,786 | |

(suite)

|  | Configuration selon l'invention | | Configuration selon l'art antérieur | |
| --- | --- | --- | --- | --- |
|  | Tore 1<br>1er étage | Tore 2<br>2nd étage | Tore 3<br>1er étage | Tore 4<br>2nd étage |
| $B_s$ (Tesla) | 1,25 | 1,25 | 0,3 | 1,25 |
| $A_L$ | 183 nH | 50 $\mu$H | 318 nH | 72 $\mu$H |
| Matériau | Nanocristallin selon l'invention ($\mu$=200) | Nanocristallin conventionnel (T45-6 d'Imphy) | Noyau ferrite MnZn à entrefer localisé | Nanocristallin conventionnel (T45-6 d'Imphy) |
| Nombre de spires | 22 | 22 | 15 | 33 |
| Résistance du fil | 68 m$\Omega$ | 5 $\Omega$ | 46 m$\Omega$ | 5$\Omega$ |

On voit donc que l'utilisation de composés nanocristallins selon l'invention permet de réduire le volume du transformateur à deux étages d'un facteur 25, comparés aux transformateurs de l'art antérieur incorporant un noyau en ferrite à entrefer localisé. En outre, un tel transformateur ne nécessite pas d'utiliser un blindage.

L'invention ne se limite pas au mode de réalisation qui a été décrit.

C'est ainsi qu'on peut envisager de réaliser des tores nanocristallins en de nombreux alliages tels que définis plus haut contenant du fer, du silicium, un élément amorphisant et d'autres éléments d'addition, qu'on peut régler les conditions de température et de mise sous contrainte pendant le recuit à des valeurs différentes de celles qui ont été indiquées, ces valeurs étant toutefois dans les intervalles revendiqués,.

Les tores réalisés peuvent être circulaires, carrés ou oblongs.

Les tores réalisés, après avoir été nanocristallisés afin d'obtenir une magnétostriction apparente à saturation proche de zéro, peuvent être enrobés d'une résine protectrice directement sur le métal à la place du boîtier protecteur, sans risque de perturbation des performances magnétiques nécessaires à un capteur de courant tel que déjà décrit.

Les inventeurs ont constaté de façon nouvelle que de tels tores pouvaient être utilisés de façon très avantageuse pour fabriquer des tores de transformateur pour des capteurs de courant alternatif et plus particulièrement pour des capteurs ayant les configurations et applications spécifiques suivantes :

- tore de compteur d'énergie à simple étage respectant les spécifications de la norme IEC 1036 pour les plus petits calibres de courant en comptage d'énergie basse fréquence (max 50A), pouvant notamment supporter de fortes composantes continues superposées et/ou de fortes composantes harmoniques superposées, n'ayant ni entrefer localisé, ni blindage, n'ayant pas de cobalt, aussi précis qu'un amorphe base cobalt, éventuellement un peu moins stable en température au dessus de 60°C qu'un amorphe base cobalt mais beaucoup plus facile à corriger, vieillissant beaucoup moins au dessus de 100°C qu'un amorphe base cobalt et se prêtant à des capteurs au moins aussi compacts.

- tore de transformateur de courant d'un compteur d'énergie à structure à double étage (calibres de courant de charge supérieurs à 50A auxquels se superposent d'éventuelles composantes continues et/ou harmoniques) ayant besoin de gamme de perméabilité encore plus réduite que précédemment à savoir $\mu$<1200, impossible à obtenir actuellement sans entrefer localisé (hors de portée des amorphes base cobalt)et obtenu actuellement avec des tores coupés en Fer, FeSi ou ferrite ce qui introduit à la fois un fort hystérésis, une forte sensibilité aux perturbations électromagnétiques extérieures, ce qui peut obliger à un blindage encombrant et coûteux.

- tore de compteur d'énergie réalisé de façon innovante en structure à simple étage grâce à une faible perméabilité (typiquement <1200) et une très forte linéarité B-H avant saturation ($\Delta\mu/\mu$ < 1% sur $\Delta$B=1T) du tore de l'invention, et remplaçant ainsi la structure à double étage des compteurs d'énergie pour calibres de courant de charge supérieurs à 50A auxquels se superposent d'éventuelles composantes continues et/ou harmoniques. A noter que cette innovation ne se limite pas à remplacer avantageusement le transformateur de courant : il remplace à la fois le transformateur d'isolement et le tore de mesure haute perméabilité (grâce à un tore à très faible perméabilité : on passe ainsi d'une structure double à simple étage)

- les sondes de courant à grande dynamique de mesure, pour le contrôle de courant des composants actifs de puissance (IGBT, GTO, thyristor...) dans les dispositifs de moyenne et forte puissance. Pour de tels équipements on utilise des structures à double étage avec un transformateur de courant en tête à faible perméabilité équivalente et un capteur de courant en dérivation basé sur un noyau magnétique à haute perméabilité et grande stabilité fréquentielle tel qu'un tore nanocristallin conventionnel ($\mu$>20 000).

Avec ces tores, on peut fabriquer les capteurs correspondants qui, par rapport aux capteurs connus, présentent les avantages qui résultent directement des avantages des tores.

## Revendications

1. Tore enroulé nanocristallisé sans entrefer localisé constitué d'un matériau nanocristallin de composition atomique :

$$[Fe_{1-a}Ni_a]100\text{-}x\text{-}y\text{-}z\text{-}\alpha\text{-}\beta\text{-}\gamma Cu_x Si_y B_z Nb_\alpha M'_\beta M''\gamma$$

avec $a \leq 0,3$, $0,6 \leq x \leq 1,5$, $10 \leq y \leq 17$, $5 \leq z \leq 14$, $2 \leq \alpha \leq 6$, $\beta \leq 7$, $\gamma \leq 8$, M' étant l'un au moins des éléments V, Cr, Al et Zn, M" étant l'un au moins des éléments C, Ge, P, Ga, Sb, In et Be, ayant une induction rémanente inférieure à 0,02T et une fréquence de coupure supérieure à 1 MHz,
ledit tore étant **caractérisé en ce qu'**il a une perméabilité $\mu$ supérieure à 1000 et inférieure ou égale à 4000, une saturation de plus de 1T, une plage d'induction où la perméabilité ne varie pas de plus de 5% supérieure à 0,9T, **en ce qu'**il est tel que $\mu$ mesuré à 20°C varie de moins de 1 % lorsque le tore est soumis à un vieillissement de 100h à 120°C, le coefficient de magnétostriction dudit tore est en valeur absolue inférieur à 2 ppm, $\mu$ varie de moins de 15% lorsque la température varie entre -25°C et +60°C, et de moins de 25% lorsque la température varie entre - 40°C et +120°C, **en ce que** $\mu$ varie de façon monotone et à peu près linéaire avec la température entre - 40°C et +120°C, et **en ce que** la teneur en nickel est inférieure à 4,5%.

2. Tore enroulé selon la revendication 1, **caractérisé en ce que** $\mu$ varie de façon monotone et à peu près linéaire avec la température entre - 100°C et + 120°C.

3. Tore enroulé selon la revendication 1 ou la revendication 2, **caractérisé en ce que** la composition de l'alliage nanocristallin est telle que, en atomes % :

$$0,8\% \leq Cu \leq 1,2\ \%$$

$$2,5\% \leq Nb \leq 3,5\%$$

$$12\ \% \leq Si \leq 16,5\%$$

$$6\ \% \leq B \leq 9\%$$

le reste étant du fer et des impuretés.

4. Dispositif de mesure électrique du type compteur d'énergie ou du type sonde de courant comprenant au moins un tore magnétique, **caractérisé en ce que** au moins un tore magnétique est un tore nanocristallin sans entrefer localisé, selon l'une quelconque des revendications 1 à 3.

5. Dispositif selon la revendication 4, **caractérisé en ce qu'**il constitue un compteur d'énergie à simple étage conforme à la norme IEC 1036 pour les calibres inférieurs à 50 A, dont le tore magnétique nanocristallin a une perméabilité $\mu$ comprise entre 1000 et 4000, et de préférence inférieure à 3000.

6. Dispositif selon la revendication 5, **caractérisé en ce qu'**il ne comporte pas de blindage.

7. Dispositif selon la revendication 5 ou 6, **caractérisé en ce qu'**il est apte à mesurer un courant comportant une forte composante continue.

**Patentansprüche**

1. Nanokristallisierter Ringbandkern ohne lokalisierten Luftspalt, der aus einem nanokristallinen Material mit der folgenden atomaren Zusammensetzung besteht:

$$[Fe_{1-a}Ni_a]100-x-y-z-\alpha-\beta-\gamma Cu_x Si_y B_z Nb_\alpha M'_\beta M''_\gamma$$

mit $a \leq 0,3$, $0,6 \leq x \leq 1,5$, $10 \leq y \leq 17$, $5 \leq z \leq 14$, $2 \leq \alpha \leq 6$, $\beta \leq 7$, $\gamma \leq 8$, wobei M' mindestens eines der Elemente V, Cr, Al und Zn ist, wobei M'' mindestens eines der Elemente C, Ge, P, Ga, Sb, In und Be ist, mit einer Remanenzinduktion, die kleiner als 0,02T ist, und einer Grenzfrequenz, die größer als 1 MHz ist, wobei der Kern **dadurch gekennzeichnet ist, dass** er eine Permeabilität $\mu$, die größer als 1000 und kleiner oder gleich 4000 ist, eine Sättigung von mehr als 1T, einen Induktionsbereich, wo die Permeabilität um nicht mehr als 5% variiert, größer als 0,9T, aufweist, dass er derart ist, dass p, bei 20°C gemessen, um weniger als 1% variiert, wenn der Kern einer Alterung von 100h bei 120°C unterzogen wird, der Magnetostriktionskoeffizient des Kerns als absoluter Betrag kleiner als 2 ppm ist, $\mu$ um weniger als 15% variiert, wenn die Temperatur zwischen -25°C und +60°C variiert, und um weniger als 25% variiert, wenn die Temperatur zwischen -40°C und +120°C variiert, dass $\mu$ monoton und ungefähr linear variiert, wenn die Temperatur zwischen -40°C und +120°C beträgt, und dass der Nickelgehalt kleiner als 4,5% ist.

2. Ringbandkern gemäß Anspruch 1, **dadurch gekennzeichnet, dass** $\mu$ monoton und ungefähr linear variiert, wenn die Temperatur zwischen -100°C und +120°C beträgt.

3. Ringbandkern gemäß Anspruch 1 oder Anspruch 2, **dadurch gekennzeichnet, dass** die Zusammensetzung der nanokristallinen Legierung in Atom-% wie folgt ist:

$$0,8\% \leq Cu \leq 1,2\%$$

$$2,5\% \leq Nb \leq 3,5\%$$

$$12\% \leq Si \leq 16,5\%$$

$$6\% \leq B \leq 9\%,$$

wobei der Rest Eisen und Verunreinigungen sind.

4. Elektrische Messvorrichtung des Energiezählertyps oder des Stromsondentyps, die mindestens einen Magnetkern aufweist, **dadurch gekennzeichnet, dass** mindestens ein Magnetkern ein nanokristalliner Kern ohne lokalisierten Luftspalt gemäß einem der Ansprüche 1 bis 3 ist.

5. Vorrichtung gemäß Anspruch 4, **dadurch gekennzeichnet, dass** sie einen Einzelstufenenergiezähler gemäß der IEC-Norm 1036 für Stärken unter 50 A bildet, dessen nanokristalliner Magnetkern eine Permeabilität $\mu$ zwischen 1000 und 4000 und vorzugsweise kleiner als 3000 aufweist.

6. Vorrichtung gemäß Anspruch 5, **dadurch gekennzeichnet, dass** sie keine Abschirmung aufweist.

7. Vorrichtung gemäß Anspruch 5 oder 6, **dadurch gekennzeichnet dass** sie geeignet ist, einen Strom zu messen, der einen starken Gleichstromanteil aufweist.

**Claims**

1. Wound nanocrystallised core without a localised air gap comprising a nanocrystalline material of atomic composition:

$$[Fe_{1-a}Ni_a]100\text{-}x\text{-}y\text{-}z\text{-}\alpha\text{-}\beta\text{-}\gamma Cu_xSi_yB_zNb_\alpha M'_\beta M''_\gamma$$

with $a \leq 0,3$, $0,6 \leq x \leq 1,5$, $10 \leq y \leq 17$, $5 \leq z \leq 14$, $2 \leq \alpha \leq 6$, $\beta \leq 7$, $\gamma \leq 8$, M' being at least one of the elements V, Cr, Al and Zn, M'' being at least one of the elements C, Ge, P, Ga, Sb, In and Be, having a remanent induction less than 0,02 T and a cut-off frequency above 1 MHz,

said core being **characterised in that** it has a permeability $\mu$ greater than 1000 and less than or equal to 4000, a saturation of more than 1 T, an induction range in which the permeability does not vary by more than 5% higher than 0,9 T, and such that $\mu$ measured at 20°C varies by less than 1% when the core is subjected to 100 hours ageing at 120°C, the magnetostriction coefficient said core has an absolute value below 2 ppm, $\mu$ varies by less than 15% when the temperature varies between -25°C and +60°C, and less than 25% when the temperature varies between -40°C and +120°C, **in that** $\mu$ varies regularly and almost linearly with temperature between -40°C and +120°C, and **in that** the nickel content is less than 4,5%,

2. A wound core according to claim 1, **characterised in that** $\mu$ varies regularly and almost linearly with temperature between -100°C and +120°C.

3. A wound core according to claim 1 or claim 2, **characterised in that** the composition of the nanocrystalline alloy is such that, in atoms % :

$$0,8\% \leq Cu \leq 1,2\ \%$$

$$2,5\% \leq Nb \leq 3,5\%$$

$$12\ \% \leq Si \leq 16,5\%$$

$$6\ \% \leq B \leq 9\%$$

the remainder being iron and impurities.

4. An electrical measuring device of the energy metering type or current probe type comprising at least one magnetic core, **characterised in that** at least one magnetic core is a nanocrystalline core without a localised air gap according to any one of claims 1 to 3.

5. A device according to claim 4, **characterised in that** it comprises a single-stage energy meter according to standard IEC 1036 for ratings below 50 A, in which the nanocrystalline magnetic core has a permeability $\mu$ between 1000 and 4000, and preferably less than 3000.

6. A device according to claim 5, **characterised in that** the device does not comprise screening.

7. A device according to claim 5 or 6, **characterised in that** the device is capable of measuring a current comprising a strong direct current component.

## FIG. 1

## FIG. 2

## FIG. 3

## FIG. 4

14

# FIG. 5

## FIG. 6

## FIG. 7

# FIG. 8

# FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6507262 B1
- WO 2004088681 A2
- FR 2823507 A1
- FR 2823507